# EUROPEAN PATENT SPECIFICATION

(11) **EP 1 536 557 B1**
(45) Date of publication and mention of the grant of the patent: **07.02.2007**
(21) Application number: 04027517.4
(22) Date of filing: 19.11.2004
(51) Int. Cl.: H03H 7/01

(54) **Intermediate frequency circuit**
Zwischenfrequenzschaltkreis
Circuit à fréquence intermédiaire

(30) Priority: 21.11.2003 JP 2003272655 U
(43) Date of publication of application: 01.06.2005
(73) Proprietor: ALPS ELECTRIC CO., LTD., Tokyo 145-8501 (JP)
(72) Inventor: Yamamoto, Masaki, Ota-ku Tokyo, 145-8501 (JP)
(74) Representative: Klunker . Schmitt-Nilson . Hirsch

(56) References cited:
- US-A- 3 358 246
- US-A- 4 376 953
- US-A- 4 795 990
- KEITH JACK: "Video demystified" 1 March 1996 (1996-03-01), HIGHTEXT PUBLICATIONS , XP002321487 * page 239 - page 368 *

## Description

### BACKGROUND OF THE INVENTION

### 1. Field of the Invention

The present invention relates to an intermediate frequency circuit, and more particularly, to an intermediate frequency circuit suitable for a common use type television tuner, capable of receiving television signals of a PAL system and a SECAM system used in Europe.

### 2. Description of the Related Art

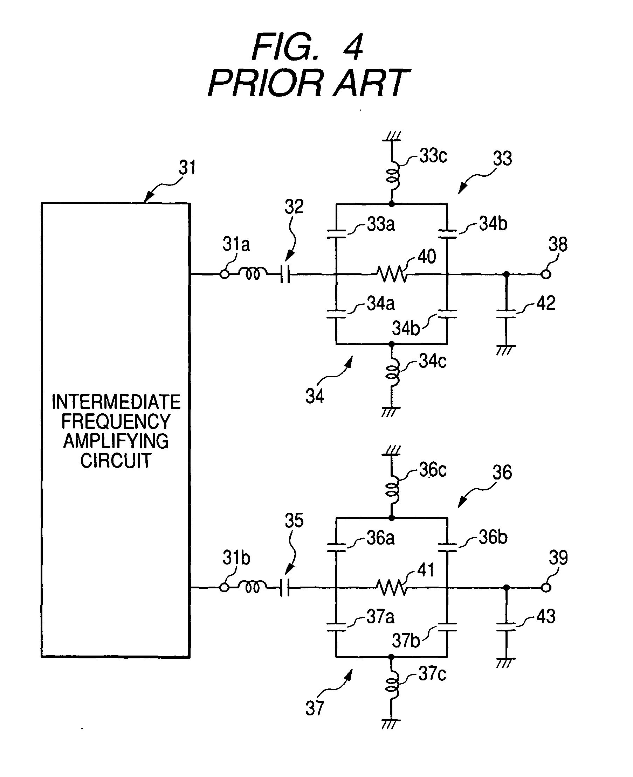

Fig. 4 shows a conventional intermediate frequency circuit. An intermediate frequency signal frequency-converted by a mixer (not shown) is input to an intermediate frequency amplifying circuit (IF amplifying circuit) 31. The IF amplifying circuit 31 has a differential amplifying circuit or the like as a balanced-type amplifying circuit.

One output terminal 31a of the IF amplifying circuit 31 is connected to one terminal of a first intermediate frequency tuning circuit (first IF tuning circuit) 32 composed of a series resonant circuit, and the other terminal of the first IF tuning circuit 32 is connected in parallel to a bridge T-type first trap circuit 33 and a bridge T-type second trap circuit 34.

Similarly, the other output terminal 31b of the IF amplifying circuit 31 is connected to one terminal of a second intermediate frequency tuning circuit (second IF tuning circuit) 35 composed of the series resonant circuit, and the other terminal of the second IF tuning circuit 35 is connected in parallel to a bridge T-type third trap circuit 36 and a bridge T-type fourth trap circuit 37.

In addition, an output terminal 38 of the first and second trap circuits 33 and 34 and an output terminal 39 of the third and fourth trap circuits 36 and 37 are connected to an intermediate frequency amplifying circuit (not shown) of a television receiver.

The resonant frequencies of the first and second IF tuning circuits 32 and 35 are set to be close to the center frequency of an intermediate frequency band (for example, about 36.15 MHz in a television tuner of European standard (German standard)).

Next, the first trap circuit 33 has a resistor 40 connected in series to a signal transmission path, two capacitors 33a and 33b each having one of their terminals respectively connected to both terminals of the resistor 40, and a coil 33c connected between a connecting point of the other terminals of the capacitors 33a and 33b and a ground.

Similarly, the second trap circuit 34 has the resistor 40, two capacitors 34a and 34b each having one of their terminals respectively connected to both terminals of the resistor 40, and a coil 34c connected between a connecting point of the other terminals of the capacitors 34a and 34b and a ground.

Next, the third trap circuit 36 has a resistor 41 connected in serial to a signal transmission path, two capacitors 36a and 36b each having one of their terminals respectively connected to both terminals of the resistor 41, and a coil 36c connected between a connecting point of the other terminals of the capacitors 36a and 36b and a ground.

Similarly, the fourth trap circuit 37 has the resistor 41, two capacitors 37a and 37b each having one of their terminals respectively connected to both terminals of the resistor 41, and a coil 37c connected between a connecting point of the other terminals of the capacitors 37a and 37b and a ground.

In addition, a capacitor 42 is provided between a ground and the output terminal 38 of the first and second trap circuits 33 and 34. Similarly, a capacitor 43 is provided between a ground and the output terminal 39 of the third and fourth trap circuits 36 and 37.

However, in a European television system using the PAL system of Europe (for example, the PAL system used in Germany), a television signal of one channel has both VHF band and UHF band, that is, 7 MHz in the VHF band and 8 MHz in the UHF band.

As a result, when the television system receives a television signal of a specific channel in the VHF band, an audio intermediate frequency signal (frequency: 40.4 MHz) of one adjacent channel and a video intermediate frequency signal (frequency: 31.9 MHz) of the other adjacent channel are close to a video intermediate frequency signal (frequency: 38.9 MHz) and an audio intermediate frequency signal (frequency: 33.4 MHz), respectively.

In addition, when the television system receives a television signal of a specific channel in the UHF band, an audio intermediate frequency signal (frequency: 41.4 MHz) of one adjacent channel and a video intermediate frequency signal (frequency: 30.9 MHz) of the other adjacent channel are close to the video intermediate frequency signal (frequency: 38.9 MHz) and the audio intermediate frequency signal (frequency: 33.4 MHz), respectively.

For this reason, when the television system receives any one of the television signal of the VHF band and the television signal of the UHF band, the video and audio intermediate frequency signals of these adjacent channels interfere with a television signal of a desired specific channel.

Therefore, for example, the trap frequency of the first trap circuit 33 and the trap frequency of the second trap circuit 34 are set in advance to the frequency (f₁=40.4 MHz) of the audio intermediate frequency signal of one adjacent channel in the VHF band and the frequency (f₂=31.9 MHz) of the video intermediate frequency signal of the other adjacent channel in the VHF band, respectively.

Similarly, the trap frequency of the third trap circuit 36 and the trap frequency of the fourth trap circuit 37 are set in advance to the frequency (f₃=41.4 MHz) of the audio intermediate frequency signal of one adjacent channel in the UHF band and the frequency (f₄=30.9 MHz) of the video intermediate frequency signal of the other adjacent channel in the UHF band, respectively.

In this manner, the audio and video intermediate frequency signals of each adjacent channel in the UHF and VHF bands are attenuated by four trap circuits (for example, see Japanese Unexamined Patent Application Publication No. 11-220670, Fig. 5).

However, according to the above-mentioned configuration, when the television system is configured to receive the television signal of any one of the VHF and UHF bands, the configuration of the intermediate frequency circuit becomes complicated because it is necessary to provide the four trap circuits for the signals of the adjacent channels in order to prevent the interference with the television signals of a desired specific channel.

In addition, in a European television system such as SECAM system employed in France. Since a video intermediate frequency and an audio intermediate frequency in the television system of the SECAM system are 32.7 MHz and 39.2 MHz, respectively, the intermediate frequency band of the SECAM system overlaps the intermediate frequency band of the PAL system, so that it is possible to commonly use a television tuner of the PAL system in the SECAM system. However, since the video intermediate frequency (32.7 MHz) of the SECAM system is approximate to the trap frequency (31.9 MHz) of the second trap circuit 34, the video intermediate frequency signal of the PAL system is attenuated by the second trap circuit 34 when the television tuner of the PAL system is also used in the SECAM system.

### SUMMARY OF THE INVENTION

Accordingly, the present invention has been made to solve the above-mentioned problems, and it is an object of the present invention to provide an intermediate frequency circuit which is capable of simplifying a circuit configuration by reducing the number of trap circuits and which is capable of attenuating an audio intermediate frequency signal of an adjacent channel of a PAL system and a video intermediate frequency signal of an adjacent channel of a SECAM system without attenuating video and audio intermediate frequency signals of the SECAM system.

In order to achieve the above-mentioned object, according to a first aspect of the present invention, there is provided an intermediate frequency circuit according to claim 1. Advantageous aspects of the invention are formulated in the dependent claims.

### BRIEF DESCRIPTION OF THE DRAWINGS

Fig. 1 is a circuit diagram showing the configuration of an intermediate frequency circuit of the present invention;
Fig. 2 is a circuit diagram showing the frequency relationship in the intermediate frequency circuit of the present invention;
Fig. 3 is a circuit diagram showing another configuration of a first trap circuit in the intermediate frequency circuit of the present invention; and
Fig. 4 is a circuit diagram showing the configuration of a conventional intermediate frequency circuit.

### DESCRIPTION OF THE PREFERRED EMBODIMENTS

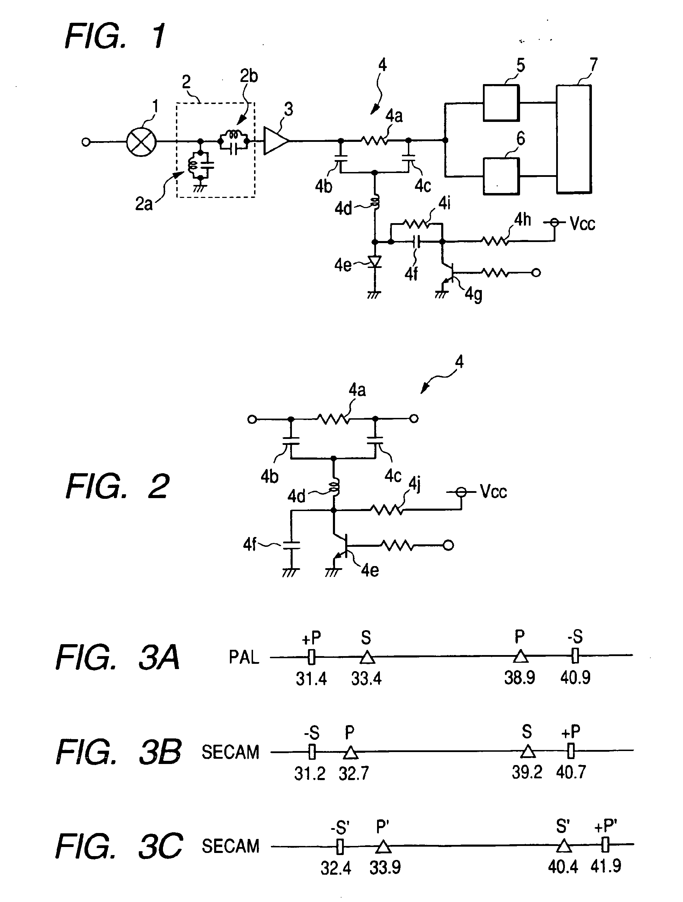

An intermediate frequency circuit of the present invention will be described with reference to Fig. 1. A received television signal of a PAL system or SECAM system and a local oscillation signal from an oscillator (not shown) are input to a mixer 1. The television signal is mixed with the local oscillation signal by the mixer 1 to be frequency-converted into an intermediate frequency signal. However, the television signal of the PAL system is converted such that video and audio carrier waves thereof become a regular video intermediate frequency (P: 38.9 MHz) and a regular audio intermediate frequency (S: 33.4 MHz), respectively, as shown in Fig. 3A. Therefore, the frequency of the video intermediate frequency signal becomes 38.9 MHz and the frequency of the audio intermediate frequency signal becomes 33.4 MHz. In addition, although not shown in Fig. 3A, the frequency of an audio frequency signal of an adjacent channel located at a high frequency side of the video intermediate frequency P becomes 40.4.MHz when its bandwidth is 7 MHz (a television signal of VHF band) and becomes 41.4 MHz when its bandwidth is 8 MHz (a television signal of UHF band). In addition, the frequency of a video frequency signal of an adjacent channel located at a low frequency side of the audio intermediate frequency S becomes 31.9 MHz when its bandwidth is 7 MHz and becomes 30.9 MHz when its bandwidth is 8 MHz.

In addition, the regular video intermediate frequency P of SECAM system and the regular audio intermediate frequency S of the SECAM system are 32.7 MHz and 39.2 MHz, respectively, as shown in Fig. 3B. However, the television signal of the SECAM system is converted by shifting a local oscillation frequency to a lower frequency by about 1.2 MHz such that a video carrier wave and an audio carrier wave have frequencies (P': 33.9 MHz and S': 40.4 MHz) higher than the regular video intermediate frequency and the regular audio intermediate frequency by 1.2 MHz, respectively, as shown in Fig. 3C. Therefore, the frequency of the video intermediate frequency signal of the SECAM system becomes 33.9 MHz and the frequency of the audio intermediate frequency signal of the SECAM system becomes 40.4 MHz. Thereby, the frequency of a video intermediate frequency signal +P' of an adjacent channel located at a high frequency side of the audio intermediate frequency signal S' becomes 41.9 MHz, and the frequency of an audio intermediate frequency signal -S' of an adjacent channel located at a low frequency side of the video intermediate frequency signal P' becomes 32.4 MHz.

One reason that shifts the frequency of the intermediate frequency signal of the SECAM system to a higher frequency by 1.2 MHz is to prevent the frequency (32.7 MHz) of the regular video intermediate frequency signal from passing by a trap frequency (31.4 MHz) of a second trap circuit 2b excessively closer thereto, as described below. Another reason is to prevent the video intermediate frequency signal of the SECAM system at a low bandwidth side of a bandwidth from attenuating so as to commonly use SAW filters 5 and 6 provided at a rear stage of the trap circuit with the PAL system.

The intermediate frequency signal is input to an intermediate frequency tuning circuit 2 at the next stage. A tuning circuit 2a for tuning almost the center frequency (for example, 37 MHz) of an intermediate frequency band and the second trap circuit 2b are provided in the intermediate frequency tuning circuit 2. The second trap circuit 2b attenuates a frequency of 31.4 MHz located at a lower frequency side lower than the audio intermediate frequency (33.4 MHz) of the PAL system by about 2 MHz (see +P of Fig. 3A). The frequency 31.4 MHz corresponds to a frequency close to two video intermediate frequencies (one is a frequency 31.9 MHz of the VHF band and the other is a frequency 30.9 MHz of the UHF band) of the adjacent channel located at the low frequency side of the audio intermediate frequency 33.4, that is, almost the center frequency of the two video intermediate frequencies.

The intermediate frequency signal that has passed through the intermediate frequency tuning circuit 2 is input to a first trap circuit 4 via an intermediate frequency amplifying circuit 3. The first trap circuit 4 uses a bridge T-type trap circuit as a base body. The bridge T-type trap circuit comprises a series resistor 4a interposed between input and output terminals, first and second capacitive elements 4b and 4c that are connected in series to each other and are connected in parallel to the series resistor 4a, and an inductance element 4d interposed between a connecting point of the first capacitive element 4b and the second capacitive element 4c and a ground. In addition, a switching element 4e is connected between a terminal of the inductance element 4d at the ground side and the ground. The switching element 4e has a switching diode and a cathode of the switching diode is connected to the ground.

In addition, the first trap circuit 4 has a first switching transistor 4g whose emitter is connected to a ground. A collector of the first switching transistor 4g is pulled up to a power source Vcc via a first resistor 4h and is connected to the terminal of the inductance element 4d at the ground side through a parallel circuit composed of a third capacitive element 4f and a second resistor 4i. In addition, by receiving the television signal of the PAL system or the television signal of the SECAM system, the first switching transistor 4g is switched such that the first switching transistor 4g is turned off or on.

Specifically, when receiving the television signal of the PAL system, since a voltage is not applied to a base of the first switching transistor 4g so that the first switching transistor 4g is turned off, the switching diode 4e is turned on by a voltage from the power source Vcc and the terminal of the inductance element 4d at the ground side is substantially connected to the ground through the diode 4e. In addition, when receiving the television signal of the SECAM system, since a voltage is applied to the base of the first switching transistor 4g so that the first switching transistor 4g is turned on, the terminal of the inductance element 4d at the ground side is connected to the ground through the third capacitive element 4f and the switching diode 4e is turned off. Therefore, the trap frequency of the first trap circuit 4 decreases when the switching diode 4e is turned on, and increases when the switching diode 4e is turned off so that the inductance element 4d is connected to the ground through the third capacitive element 4f. In addition, when the trap frequency is low, the first frequency is set by values of the series resistor 4a, the first and second capacitive elements 4b and 4c and the inductance element 4d such that its frequency becomes a frequency close to 40.4 MHz and 41.4 MHz, that is, a frequency between 40.4 MHz and 41.4 MHz. In addition, the second frequency having a high trap frequency is set by a value of the third capacitive element 4f such that its frequency becomes about 41.9 MHz.

Therefore, when the television system receives the television signal of the PAL system, it is possible to attenuate the audio intermediate frequency signals of the adjacent channels in the VHF and UHF bands that are located at a high frequency side of the video intermediate frequency signal. In addition, when the television system receives the television signal of the SECAM system, it is possible to attenuate the video intermediate frequency signal (its frequency is 41.9 MHz) of the adjacent channel located at a high frequency side of the audio intermediate frequency signal (its frequency is 40.4 MHz). In addition, since the frequency of the intermediate frequency signal of the SECAM system is shifted to a higher frequency by about 1.2 MHz, the frequency (33.9 MHz) of its video intermediate frequency signal is away from the trap frequency of the second trap circuit 2b by about 2.5 MHz so that the video frequency signal is not attenuated.

In addition, since the trap frequency of the second trap circuit 2b is 31.4 MHz, it is possible to attenuate the video intermediate frequency signals (their frequencies are 30.9 MHz and 31.9 MHz) of the adjacent channel located at a low frequency side of the audio intermediate frequency signal (its frequency is 33.4 MHz) of the PAL system, and to attenuate the audio intermediate frequency signal (its frequency is 32.4 MHz) of the adjacent channel located at a low frequency side of the video intermediate frequency signal (its frequency is 33.9 MHz) of the SECAM system.

The SAW filters 5 and 6 are connected in parallel to a next stage of the first trap circuit 4. One SAW filter 5 has a broadband characteristic that passes the video intermediate frequency signal of the PAL system and the video intermediate frequency signal of the SECAM system (their frequencies are 38.9 MHz and 33.9 MHz, respectively) after lowering the signals from their peak values by about 6 dB, and the other SAW filter 6 is a characteristic that passes the audio intermediate frequency signal of the PAL system and the audio intermediate frequency signal of the SECAM system (their frequencies are 33.4 MHz and 40.4 MHz, respectively) in a narrowband.

The intermediate frequency signals that have passed through the two SAW filters 5 and 6 are demodulated by a demodulator 7 at a next stage of the two SAW filters 5 and 6 to be converted into a video signal and an audio signal.

Fig. 2 shows a different configuration of the first trap circuit 4. In this configuration, a switching element 4e is composed of a second switching transistor. An emitter of the switching element 4e is connected to a ground, and a collector of the switching element 4e is connected to a terminal of an inductance element 4d at the ground side and is pull up to a power source Vcc through a third resistor 4j. In addition, a third capacitive element 4f is connected between the terminal of the inductance element 4d at the ground side and the ground. According to the configuration, when the second switching transistor is turned on, a trap frequency becomes a first frequency, and when the second switching transistor is turned off, the trap frequency becomes a second frequency. In addition, the trap frequency is switched by only the second switching transistor.

According to the intermediate frequency circuit of the present invention, the trap frequency of the second trap circuit is close to a video intermediate frequency of an adjacent channel located at a low frequency side of an audio intermediate frequency of the PAL system. The first trap circuit is switched such that the first trap circuit attenuates a first frequency or a second frequency which is higher than the first frequency close to an audio intermediate frequency of an adjacent channel located at a high frequency side of a video intermediate frequency of the PAL system. A video intermediate frequency signal of an adjacent channel located at a higher frequency side than an audio intermediate frequency signal of the SECAM system is located in the second frequency, by shifting the frequency of an intermediate frequency signal of the SECAM system to a higher frequency than a regular frequency. Therefore, it is possible to attenuate an audio intermediate frequency signal of an adjacent channel located at a high frequency side of a video intermediate frequency signal of the PAL system, a video intermediate frequency signal of an adjacent channel located at a low frequency side of the audio intermediate frequency signal, an audio intermediate frequency signal of an adjacent channel located at a low frequency side of an video intermediate frequency signal of the SECAM system, and a video intermediate frequency signal of an adjacent channel located at a high frequency side of the audio intermediate frequency signal by using the two trap circuits.

Further, the first frequency is a frequency between 40.4 MHz and 41.4 MHz, and the second frequency is about 41.9 MHz. Therefore, it is possible to attenuate audio intermediate frequency signals of the two adjacent channels in the VHF and UHF bands located at a high frequency side of the video intermediate frequency signal of the PAL system.

Furthermore, the trap frequency of the second trap circuit is a frequency between 30.9 MHz and 31.9 MHz. Therefore, it is possible to attenuate video intermediate frequency signals of two adjacent channels in the VHF and UHF bands located at a low frequency side of the audio intermediate frequency signal of the PAL system and audio intermediate frequency signals of adjacent channels located at a low frequency side of a video intermediate frequency signal of the SECAM system.

Further, the first trap circuit has a bridge T-type trap circuit. The bridge T-type trap circuit includes a series resistor interposed between input and output terminals thereof, first and second capacitive elements that are connected in series to each other and are connected in parallel to the series resistor, and an inductance element interposed between a connecting point of the first capacitive element and the second capacitive element and a ground. A terminal of the inductance element at the ground side is connected to the ground via a switching element or is connected to the ground via a third capacitive element. Therefore, the trap frequency of the first trap circuit is switched in two ways.

Furthermore, the circuit further comprises a first switching transistor having its emitter connected to the ground and its collector pulled up to a power source via a first resistor. The switching element has a switching diode. A cathode of the switching diode is connected to the ground, and an anode of the switching diode is connected to the terminal of the inductance element at the ground side. The third capacitive element and a second resistor are connected in parallel between the collector of the first switching transistor and the terminal of the inductance element at the ground side. Therefore, when the first switching transistor is turned on/off according to the reception of television signals of the PAL and SECAM systems, the trap frequency of the first trap circuit is switched in two ways.

Furthermore, the switching element has a second switching transistor having its emitter connected to the ground. A collector of the second switching transistor is connected to the terminal of the inductance element at the ground side and is pulled up to a power source via a third resistor. The third capacitive element is connected between the terminal of the inductance element at the ground side and the ground. Therefore, when the second switching transistor is turned on/off according to the reception of television signals of the PAL and SECAM systems, the trap frequency of the first trap circuit is switched in two ways.

## Claims

1. An intermediate frequency circuit comprising:
a mixer (1) for converting a television signal of a PAL system or SECAM system into an intermediate frequency signal;
SAW (5,6) filters provided at a next stage of the mixer; and;
a first trap circuit (4) and a second trap circuit (2b) interposed between the mixer and the SAW filters,
wherein the reception channel bandwidth of the PAL system includes two of reception channel bandwidths that have a first channel bandwidth and a second channel bandwidth, which is wider than the first channel bandwidth, depending on a channel to be received,
the trap frequency of the second trap circuit is set at a frequency between a video intermediate frequency of an adjacent channel which is lower than a reception channel during reception of the channel having the first channel bandwidth and a video intermediate frequency of an adjacent channel which is lower than a reception channel during reception of the channel having the second channel bandwidth,
the first trap circuit (4) is switched such that the first trap circuit attenuates a first frequency or a second frequency which is higher than the first frequency, the frequencies being higher than a video intermediate frequency of the PAL system,
the first frequency is set at a frequency between an audio intermediate frequency of an adjacent channel which is higher than a reception channel during reception of the channel having the first channel bandwidth and an audio intermediate frequency of an adjacent channel which is higher than a reception channel during reception of the channel having the second channel bandwidth, and
the second frequency is located at the frequency of a video intermediate frequency signal of an adjacent channel located at a higher frequency side than an audio intermediate frequency signal of the SECAM system after shifting the frequency of an intermediate frequency signal of the SECAM system to a higher frequency than a standard intermediate frequency.

2. The intermediate frequency circuit according to claim 1,
wherein the first frequency is a frequency between 40.4 MHz and 41.4 MHz, and the second frequency is about 41.9 MHz.

3. The intermediate frequency circuit according to claim 2,
wherein the trap frequency of the second trap circuit is a frequency between 30.9 MHz and 31.9 MHz.

4. The intermediate frequency circuit according to any one of claims 1 to 3,
wherein the first trap circuit has a bridge T-type trap circuit, the bridge T-type trap circuit including a series resistor interposed between input and output terminals thereof, first and second capacitive elements that are connected in series to each other and are connected in parallel to the series resistor, and an inductance element interposed between a connecting point of the first capacitive element and the second capacitive element and a ground, and
a terminal of the inductance element at the ground side is connected to the ground via a switching element or is connected to the ground via a third capacitive element.

5. The intermediate frequency circuit according to claim 4,
wherein the circuit further comprises a first switching transistor having its emitter connected to the ground and its collector pulled up to a power source via a first resistor,
the switching element has a switching diode,
a cathode of the switching diode is connected to the ground, and an anode of the switching diode is connected to the terminal of the inductance element at the ground side, and
the third capacitive element and a second resistor are connected in parallel between the collector of the first switching transistor and the terminal of the inductance element at the ground side.

6. The intermediate frequency circuit according to claim 4,
wherein the switching element has a second switching transistor having its emitter connected to the ground,
a collector of the second switching transistor is connected to the terminal of the inductance element at the ground side and is pulled up to a power source via a third resistor, and
the third capacitive element is connected between the terminal of the inductance element at the ground side and the ground.

## Patentansprüche

1. Zwischenfrequenzschaltung, aufweisend:
einen Mischer (1) für das Umwandeln eines Fernsehsignals eines PAL-Systems oder SECAM-Systems in ein Zwischenfrequenzsignal;
SAW-Filter (5, 6), die in einer dem Mischer nachfolgenden Stufe vorgesehen sind, und;
eine erste Sperrschaltung (4) und eine zweite Sperrschaltung (2b), die zwischen dem Mischer und dem SAW-Filter angordnet sind,
wobei die Empfangskanalbandbreite des PAL-Systems zwei Empfangskanalbandbreiten mit einer ersten Kanalbandbreite und einer zweiten Kanalbandbreite, die breiter ist als die erste Kanalbandbreite, abhängig von dem zu empfangenenden Kanal, aufweist,
die Sperrfrequenz der zweiten Sperrschaltung auf eine Frequenz zwischen einer Videozwischenfrequenz eines benachbarten Kanals, der niedriger ist als ein Empfangskanal während des Empfangs des Kanals mit der ersten Kanalbandbreite, und einer Videozwischenfrequenz eines benachbarten Kanals, der niedriger ist als ein Empfangskanal während des Empfangs des Kanals mit der zweiten Kanalbandbreite, eingestellt ist,
die erste Sperrschaltung (4) so geschaltet ist, dass die erste Sperrschaltung eine erste Frequenz oder eine zweite Frequenz, die höher ist als die erste Frequenz, dämpft, wobei die Frequenzen höher sind als eine Videozwischenfrequenz des PAL-Systems,
die erste Frequenz auf eine Frequenz zwischen einer Audiozwischenfrequenz eines benachbarten Kanals, der höher ist als ein Empfangskanal während des Empfangs des Kanals mit der ersten Kanalbandbreite, und einer Audiozwischenfrequenz eines benachbarten Kanals, der höher ist als ein Empfangskanal während des Empfangs des Kanals mit der zweiten Kanalbandbreite, eingestellt ist, und
die zweite Frequenz sich auf der Frequenz eines Videozwischenfrequenzsignals eines benachbarten Kanals befindet, das sich auf einer höheren Frequenzseite befindet als ein Audiozwischenfrequenzsignal des SECAM-Systems nach dem Verschieben der Frequenz eines Zwischenfrequenzsignals des SECAM-Systems auf eine höhere Frequenz als eine Standardzwischenfrequenz.

2. Zwischenfrequenzschaltung nach Anspruch 1,
wobei die erste Frequenz eine Frequenz zwischen 40,4 MHz und 41,4 MHz ist und die zweite Frequenz etwa 41,9 MHz ist.

3. Zwischenfrequenzschaltung nach Anspruch 2,
wobei die Sperrfrequenz der zweiten Sperrschaltung eine Frequenz zwischen 30,9 MHz und 31,9 MHz ist.

4. Zwischenfrequenzschaltung nach einem der Ansprüche 1 bis 3,
wobei die erste Sperrschaltung eine Brücken-Sperrschaltung vom T-Typ hat, wobei die Brücken-Sperrschaltung vom T-Typ einen Reihenwiderstand, der zwischen einem Eingangs- und einem Ausgangsanschluss davon angeordnet ist, ein erstes und ein zweites kapazitives Element, die in Reihe zueinander geschaltet sind und parallel zu dem Reihenwiderstand geschaltet sind, und ein Induktivitätselement, das zwischen einem Verbindungspunkt des ersten kapazitiven Elements und des zweiten kapazitiven Elements und einer Masse angeordnet ist, aufweist, und
ein Anschluss des Induktivitätselements an der Masseseite über ein Schaltelement mit der Masse verbunden ist oder über ein drittes kapazitives Element mit der Masse verbunden ist.

5. Zwischenfrequenzschaltung nach Anspruch 4,
wobei die Schaltung ferner einen ersten Schalttransistor aufweist, dessen Emitter mit der Masse verbunden ist und dessen Kollektor über einen ersten Widerstand zu einer Energiequelle hochgezogen ist,
das Schaltelement eine Schaltdiode hat,
eine Kathode der Schaltdiode mit der Masse verbunden ist und eine Anode der Schaltdiode mit dem Anschluss des Induktivitätselements auf der Masseseite verbunden ist und
das dritte kapazitive Element und ein zweiter Widerstand parallel zwischen den Kollektor des ersten Schalttransistors und den Anschluss des Induktivitätselements auf der Masseseite geschaltet sind.

6. Zwischenfrequenzschaltung nach Anspruch 4,
wobei das Schaltelement einen zweiten Schalttransistor hat, dessen Emitter mit der Masse verbunden ist,
ein Kollektor des zweiten Schalttransistors mit dem Anschluss des Induktivitätselements auf der Masseseite verbunden ist und über einen dritten Widerstand zu einer Energiequelle hochgezogen ist, und
das dritte kapazitive Element zwischen den Anschluss des Induktivitätselements auf der Masseseite und die Masse geschaltet ist.

## Revendications

1. Circuit à fréquence intermédiaire, comprenant :
- un mélangeur (1), permettant de convertir un signal de télévision d'un système PAL ou d'un système SECAM en un signal à fréquence intermédiaire ;
- des filtres OAS (5, 6), placés à un étage suivant du mélangeur et
- un premier circuit bouchon (4) et un deuxième circuit bouchon (2b), interposés entre le mélangeur et les filtres OAS ;
dans lequel
la largeur de bande du canal de réception du système PAL comporte deux des largeurs de bande du canal de réception, qui ont une première largeur de bande de canal et une deuxième largeur de bande de canal, qui est plus large que la première largeur de bande de canal, en fonction du canal à recevoir,
la fréquence bouchon du deuxième circuit bouchon est réglée à une fréquence, comprise entre une fréquence vidéo intermédiaire d'un canal adjacent, qui est inférieure à celle d'un canal de réception durant la réception du canal ayant la première largeur de bande de canal et une fréquence vidéo intermédiaire d'un canal adjacent, qui est inférieure à celle d'un canal de réception durant la réception du canal ayant la deuxième largeur de bande de canal,
le premier circuit bouchon (4) est commuté, de sorte que le premier circuit bouchon atténue une première fréquence ou une deuxième fréquence, qui est supérieure à la première fréquence, les fréquences étant supérieures à une fréquence vidéo intermédiaire du système PAL,
la première fréquence est réglée à une fréquence, comprise entre une fréquence audio intermédiaire d'un canal adjacent, qui est supérieure à celle d'un canal de réception durant la réception du canal ayant la première largeur de bande et une fréquence audio intermédiaire d'un canal adjacent, qui est supérieure à celle d'un canal de réception durant la réception du canal ayant la deuxième largeur de bande de canal et
la deuxième fréquence est située à la fréquence d'un signal vidéo à fréquence intermédiaire d'un canal adjacent, situé d'un côté à fréquence supérieure à celle d'un signal audio à fréquence intermédiaire du système SECAM, après avoir décalé la fréquence d'un signal à fréquence intermédiaire du système SECAM vers une fréquence, supérieure à une fréquence intermédiaire normalisée.

2. Circuit à fréquence intermédiaire selon la revendication 1,
dans lequel la première fréquence est une fréquence, comprise entre 40,4 MHz et 41,4 MHz et la deuxième fréquence est d'environ 41,9 MHz.

3. Circuit à fréquence intermédiaire selon la revendication 2,
dans lequel la fréquence bouchon du deuxième circuit bouchon est une fréquence, comprise entre 30,9 MHz et 31,9 MHz.

4. Circuit à fréquence intermédiaire selon l'une quelconque des revendication 1 à 3,
dans lequel
le premier circuit bouchon a un circuit bouchon, de type en T, à pont, le circuit bouchon, de type en T, à pont comportant une résistance en série, interposée entre les bornes d'entrée et de sortie de celui-ci, les premier et deuxième éléments capacitifs qui sont reliés mutuellement en série et sont reliés en parallèle à la résistance en série et un élément d'inductance, interposé entre un point de connexion du premier élément capacitif et le deuxième élément capacitif et une masse et
une borne de l'élément d'inductance, du côté masse, est reliée à la masse par l'intermédiaire d'un élément de commutation ou est reliée à la masse par l'intermédiaire d'un troisième élément capacitif.

5. Circuit à fréquence intermédiaire selon la revendication 4,
dans lequel
le circuit comprend, en outre, un premier transistor de commutation, dont l'émetteur est relié à la masse et dont le collecteur est connecté à un bloc d'alimentation, par l'intermédiaire d'une première résistance,
l'élément de commutation a une diode de commutation,
une cathode de la diode de commutation est reliée à la masse et une anode de la diode de commutation est reliée à la borne de l'élément d'inductance, du côté masse et
le troisième élément capacitif et une deuxième résistance sont reliés en parallèle entre le collecteur du premier transistor de commutation et la borne de l'élément d'inductance, du côté masse.

6. Circuit à fréquence intermédiaire selon la revendication 4,
dans lequel
l'élément de commutation a un deuxième transistor de commutation dont l'émetteur est relié à la masse,
un collecteur du deuxième transistor de commutation est relié à la borne de l'élément d'inductance, du côté masse et est connecté à un bloc d'alimentation, par l'intermédiaire d'une troisième résistance et
le troisième élément capacitif est connecté entre la borne de l'élément d'inductance, du côté masse et la masse.
